# EUROPÄISCHE PATENTSCHRIFT

(11) **EP 1 125 356 B1**
(45) Veröffentlichungstag und Bekanntmachung des Hinweises auf die Patenterteilung: **11.06.2003**
(21) Anmeldenummer: 99971976.8
(22) Anmeldetag: 05.11.1999
(51) Int. Cl.: H02M 7/00

(54) **STROMRICHTERGERÄT MIT GLEICH- UND WECHSELSPANNUNGSVERSCHIENUNG**
POWER CONVERTER WITH DIRECT VOLTAGE AND ALTERNATING VOLTAGE BUSES
CONVERTISSEUR DE COURANT AVEC BARRES OMNIBUS A TENSION CONTINUE ET A TENSION ALTERNATIVE

(30) Priorität: 06.11.1998 DE 19851161
(43) Veröffentlichungstag der Anmeldung: 22.08.2001
(73) Patentinhaber: DaimlerChrysler AG, 70567 Stuttgart (DE)
(72) Erfinder: DRABON, Rodscha, D-68535 Edingen-Neckarhausen (DE)
(74) Vertreter: Akers, Noel James
(86) Internationale Anmeldenummer: EP9908500
(87) Internationale Veröffentlichungsnummer: WO00028649

(56) Entgegenhaltungen:
- DE-A- 19 710 881
- DE-A- 19 717 550
- US-A- 5 672 070
- PATENT ABSTRACTS OF JAPAN vol. 012, no. 265 (E-637), 23. Juli 1988 (1988-07-23) & JP 63 048160 A (FUJI ELECTRIC CO LTD), 29. Februar 1988 (1988-02-29)

## Beschreibung

Die Erfindung bezieht sich auf ein Stromrichtergerät mit mehreren Leistungshalbleitem und Gleich- und Wechselspannungsverschienung zur elektrischen Kontaktierung von Gleich- und Wechselspannungsanschlüssen der Leistungshalbleiter.

Unter dem Begriff "Verschienung" wird dabei aligemein ein System aus mehreren, mit unterschiedlichem elektrischem Potential beaufschlagten flachen, bandförmigen Stromschienen aus elektrisch gut leitendem Material verstanden, wobei der räumliche Abstand zwischen den Schienen und die Schienen-Gesamtkonfiguration starr festgelegt sind, um genau definierte Induktivitäten und Kapazitäten der Verschienung zu erzielen, welche unabhängig von Montageeinflüssen sind.

Ein solches Stromrichtergerät ist aus der DE 44 12 990 A1 bekannt Dort wird eine Stromrichteranlage mit flüssigkeits- oder luftgekühlten Leistungshalbleitern und Gleichspannungszwischenkreis beschrieben, bei der das Verbindungsschienensystem komplett als Sandwichsystem ausgeführt ist. Die Gleichspannungsverschienung und die Wechselspannungsverschienung sind dabei unter Zwischenlage von Isolierschichten zusammengefaßt, wodurch beispielsweise ein fünf- oder siebenschichtiger Sandwichaufbau gebildet wird. Allerdings müssen bei dieser Konfiguration die vorgeschriebenen Kriechwege zwischen den auf unterschiedlichem elektrischem Potential befindlichen Verschienungen beachtet werden, um die elektrische Sicherheit dauerhaft zu gewährleisten. Insbesondere bei höheren Spannungen ergibt sich hierdurch ein relativ hoher Isolieraufwand, der mit einem erhöhten Kostenaufwand einhergeht.

Ein Stromrichtergerät mit Gleich- und Wechselspannungsverschienung ist auch aus der JP 63048160 bekannt. Die Schienen für Gleich- und Wechselspannung sind über Haltestifte rückseitig gestützt.

Der Erfindung liegt die Aufgabe zugrunde, ein Stromrichtergerät mit Gleich- und Wechselspannungsverschienung der eingangsgenannten Art anzugeben, bei dem die Verschienung mit reduziertem Kostenaufwand herstellbar ist.

Diese Aufgabe wird in Verbindung mit den Merkmalen des Oberbegriffes des Patentanspruches 1 dadurch gelöst, daß die Verschienung zweigeteilt ausgebildet ist, so daß die Wechselspannungsverschienung und die Gleichspannungsverschienung keine körperliche Verbindung untereinander aufweisen.

Die mit der Erfindung erzielbaren Vorteile bestehen insbesondere darin, daß zwischen der Wechselspannungsverschienung und der Gleichspannungsverschienung keine Kriechwege, sondern nur die geforderten Luftstrecken zu berücksichtigen sind. Durch dieses Konzept wird insbesondere auch bei höheren Spannungen eine flache, raumsparend aufgebaute, kostengünstige und niederinduktive Verschienung erzielt.

Vorteilhafte Ausgestaltungen der Erfindung sind in den Unteransprüchen gekennzeichnet.

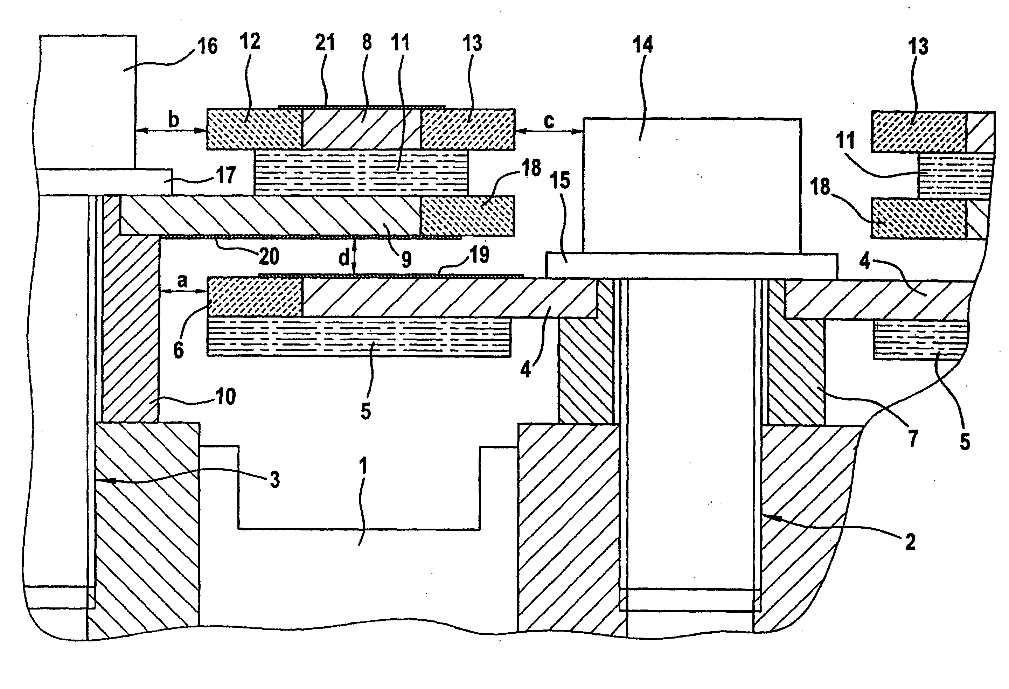

Die Erfindung wird nachstehend an Hand des in der einzigen Fig. dargestellten Ausführungsbeispieles erläutert.

In der Fig. ist ein Schnitt durch einen Ausschnitt eines Stromrichtergerätes gezeigt. Es ist ein Leistungshalbleiter 1 - vorzugsweise ein IGBT-Modul - zu erkennen, welcher einen Wechselspannungsanschluß 2 und einen Gleichspannungsanschluß 3 aufweist. Wechselspannungsanschluß 2 und Gleichspannungsanschluß 3 sind als Buchsen für den Eingriff von Schraubbolzen ausgebildet. Das Stromrichtergerät besitzt weitere, hier nicht dargestellte Leistungshalbleiter, welche vorzugsweise in allgemein bekannter Art und Weise auf einer flüssigkeits- oder luftgekühlten Kühlplatte montiert sind.

Der Wechselspannungsanschluß 2 ist mit einer flachen, bandförmigen Wechselspannungsverschienung 4 kontaktiert, wobei die Wechselspannungsverschienung 4 mit einer Isolierschicht 5 bedeckt ist (Ober- oder Unterseite) und stimseitige Kanten an Durchbrüchen in der Verschienung mit einer Isolierschicht 6 (beispielsweise Isolierring oder anliegende Isolierfolie) versehen sind. Um den gewünschten Abstand zwischen der Oberfläche des Leistungshalbleiters und der Wechselspannungsverschienung zu erzielen, ist eine entsprechend lange Buchse 7 in eine Bohrung der Wechselspannungsverschienung 4 eingepreßt. Zur elektrischen Kontaktierung zwischen dem Wechselspannungsanschluß 2 und der Wechselspannungsverschienung 4 greift ein Schraubbolzen 14 durch die Buchse 7 in die Wechseispannungsverschienung 2, wobei zweckmäßig eine Unterlegscheibe 15 zwischen dem Schraubbolzen 14 und der Wechselspannungsverschienung 4 eingelegt ist.

Außer der Wechselspannungsverschienung 4 besitzt das Stromrichtergerät eine positive bzw. negative Gleichspannungsverschienung 8 bzw. 9 für die Kontaktierung des positiven bzw. negativen Gleichspannungspotentials. Die Gleichspannungsverschienung 8/9 ist unter Zwischenlage einer Isolierschicht 11 als dreischichtiges Sandwichsystem ausgeführt. Stirnseitige Kanten an Durchbrüchen der Gleichspannungsverschienung 8/9 sind mit Isolierschichten 12, 13, 18 (beispielsweise Isolierringe) versehen.

Die elektrische Kontaktierung des Gleichspannungsanschlusses 3 mit der negativen Gleichspannungsverschienung 9 erfolgt in gleicher Art und Weise, wie dies vorstehend für die Kontaktierung des Wechselspannungsanschlusses 2 erläutert ist. Ein Schraubbolzen 16 greift durch eine mit einer eingepreßten Buchse 10 gewünschter Länge versehene Bohrung der Gleichspannungsverschienung 9 in den Gleichspannungsanschluß 3 des Leistungshalbleiters 1, wobei zweckmäßig eine Unterlegscheibe 17 zwischen dem Schraubbolzen 16 und der Gleichspannungsverschienung 9 eingelegt ist.

Die nicht dargestellte elektrische Kontaktierung der positiven Gleichspannungsverschienung 8 mit einem Gleichspannungsanschluß eines Leistungshalbleiters des Stromrichtergerätes erfolgt in gleicher Art und Weise.

Das wesentliche Merkmal der vorstehend erläuterten, vorzugsweise aus Kupfer gefertigten Verschienung des Stromrichtergerätes ist die räumliche Zweiteilung der Wechselspannungsverschienung 4 einerseits und der Gleichspannungsverschienung 8/9 andererseits. Aufgrund dieses konstruktiven Aufbaus sind zwischen der Wechselspannungsverschienung 4 und der Gleichspannungsverschienung 8/9 keine Kriechwege vorhanden. Es sind lediglich die in Abhängigkeit der elektrischen Potentiale geforderten Luftstrecken einzuhalten und dementsprechend konstruktiv zu berücksichtigen.

In der Fig. sind hierzu beispielhaft die interessierende Luftstrecke a zwischen der Buchse 10 und der Wechselspannungsverschienung 4, die Luftstrecke b zwischen dem Schraubbolzen 16 und der positiven Gleichspannungsverschienung 8, die Luftstrecke c zwischen dem Schraubbolzen 14 und der Gleichspannungsverschienung 8/9 und die Luftstrecke d zwischen der Wechselspannungsverschienung 4 und der negativen Gleichspannungsverschienung 9 gezeigt.

Der elektrischen Sicherheit dienen auch die vorstehend erwähnten Isolierschichten 6, 12, 13 und 18 (Isolierringe), welche sich ringförmig längs der Stirnflächen von durch Wechselspannungsanschlüsse und Gleichspannungsanschlüsse bedingten Durchbrüchen in den Verschienungen erstrecken. Es ist jedoch auch möglich, die auf jeder Verschienung aufgebrachten Isolierfolien 19, 20, 21 an den Kanten herunterzuziehen und auf Isolierringe 6, 12, 13, 18 ganz zu verzichten.

## Patentansprüche

1. Stromrichtergerät mit mehreren Leistungshalbleitern (1) und Gleich- und Wechselspannungsverschienung (8/9, 4) zur elektrischen Kontaktierung von Gleich- und Wechselspannungsanschlüssen (3, 2) der Leistungshalbleiter (1), **dadurch gekennzeichnet,**
- **daß** die Verschienung zweigeteilt ausgebildet ist, so daß die Wechselspannungsverschienung (4) und die Gleichspannungsverschienung (8/9) keine körperliche Verbindung untereinander aufweisen und
- **daß** die positive und die negative Gleichspannungsverschienung (8/9) unter Zwischenlage einer Isolierschicht (11) als dreischichtiges Sandwichsystem ausgeführt ist.

2. Stromrichtergerät nach Anspruch 1, **dadurch gekennzeichnet, daß** die Wechselspannungsverschienung (4) und/oder die Gleichspannungsverschienung (8/9) an durch Wechselspannungsanschlüsse (2) oder Gleichspannungsanschlüsse (3) bedingten Durchbrüchen mit stirnseitigen Isolierschichten (6, 12, 13, 18) versehen ist.

3. Stromrichtergerät nach Anspruch 1 und/oder 2, **dadurch gekennzeichnet, daß** die Verschienung (4, 8/9) zur elektrischen Kontaktierung mit Anschlüssen (2, 3) der Leistungshalbleiter (1) mit eingepreßten Buchsen (7,10) gewünschter Länge versehen ist.

## Claims

1. Converter having a number of power semiconductors (1) and a DC and AC voltage busbar system (8/9, 4) for making electrical contact with DC and AC voltage connections (3, 2) of the power semiconductors (1),
**characterized**
- **in that** the busbar system is designed such that it is split in two, such that the AC voltage busbar system (4) and the DC voltage busbar system (8/9) have no physical connection to one another, and
- **in that** the positive and the negative DC voltage busbar system (8/9) is in the form of a three-layer sandwich system, with the interposition of an insulating layer (11).

2. Converter according to Claim 1, **characterized in that** the AC voltage busbar system (4) and/or the DC voltage busbar system (8/9) are/is provided with endface insulating layers (6, 12, 13, 18) on apertures which are governed by AC voltage connections (2) or DC voltage connections (3).

3. Converter according to Claim 1 and/or 2, **characterized in that** the busbar system (4, 8/9) is provided with pushed-in female connectors (7, 10) of a desired length in order to make electrical contact with connections (2, 3) of the power semiconductors (1).

## Revendications

1. Convertisseur statique comportant plusieurs semiconducteurs de puissance (1) et un arrangement de rails pour tension continue et pour tension alternative (8/9, 4) destinés à établir le contact électrique avec les bornes de tension continue et de tension alternative (3, 2) des semiconducteurs de puissance (1), **caractérisé en ce**
- **que** l'arrangement de rails est constitué de deux parties de manière à ce que l'arrangement de rails pour tension alternative (4) et l'arrangement de rails pour tension continue (8/9) ne présentent aucune liaison physique entre eux et
- **que** l'arrangement de rails pour tension continue positive et négative (8/9) est réalisé en intercalant une couche isolante (11) pour constituer un système en sandwich à trois couches.

2. Convertisseur statique selon la revendication 1, **caractérisé en ce que** l'arrangement de rails pour tension alternative (4) et/ou l'arrangement de rails pour tension continue (8/9) est muni de couches isolantes (6, 12, 13, 18) frontales au niveau des traversées liées aux bornes de tension alternative (2) ou aux bornes de tension continue (3).

3. Convertisseur statique selon la revendication 1 et/ou 2, **caractérisé en ce que** l'arrangement de rails (4, 8/9) est muni de douilles encastrées (7, 10) de longueur souhaitée pour établir le contact électrique avec les bornes (2, 3) des semiconducteurs de puissance (1).
